# EUROPEAN PATENT APPLICATION

(11) **EP 2 343 172 A1**
(43) Date of publication of application: **13.07.2011**
(21) Application number: 11150199.5
(22) Date of filing: 05.01.2011
(51) Int. Cl.: B28D 1/22, B28D 5/00, H01L 21/00, H01L 27/142, H01L 31/18

(54) **Groove machining tool for use with a thin-film solar cell and an angle regulation structure**

(30) Priority: 08.01.2010 JP 2010002498
(71) Applicant: Mitsuboshi Diamond Industrial Co., Ltd., Suita-city, Osaka 564-0044 (JP)
(72) Inventor: Soyama, Masanobu, Suita City Osaka 564-0044 (JP)
(74) Representative: TBK

(57) **Abstract**

To be able to accurately adjust an angle using a simple operation when mounting a groove machining tool into a holder, there is provided a groove machining tool for use with a thin-film solar cell. The groove machining tool is retained by a holder, is caused to move together with the holder over a thin film of an integrated thin-film solar cell in one direction, and forms a groove on the thin film extending in one direction and has a tool body. The blade tip part is formed on a tip end of the tool body and has blade tips for machining grooves disposed at a tip end. An angle regulation unit is disposed on the tool body so that the blade tip part is fixed in a predetermined orientation with regard to the direction of formation of the groove when being retained by the holder.

## Description

### CROSS-REFERENCE TO RELATED APPLICATIONS

This application claims priority to Japanese Patent Application No. 2010-2498 filed on January 8, 2010. The entire disclosure of Japanese Patent Application No. 2010-2498 is hereby incorporated herein by reference.

### BACKGROUND OF THE INVENTION

### 1. Field of the Invention

The present invention relates to a groove machining tool, and particularly to a groove machining tool that is retained in a holder and is caused to move together with the holder in one direction over an integrated thin-film solar cell to form a groove extending in one direction. Also, the present invention relates to an angle regulation structure that regulates the mounting angle of the groove machining tool.

### 2. Description of the Related Art

An integrated thin-film solar cell is provided as a thin-film solar cell wherein a plurality of layers of thin film is laminated, as described in Japanese Unexamined Patent Application Publication No. 2002-33498, for example. A lower electrode film composed of a molybdenum film is formed on a glass or other substrate in the integrated thin-film solar cell described in Japanese Unexamined Patent Application Publication No. 2002-33498. Thereafter, the lower electrode film is divided into narrow card shapes. Next, a compound semiconductor film is formed on the lower part of the electrode film, including a CIGS film or other chalcopyrite structure compound semiconductor film. Thereafter, a stripe-shaped portion of the semiconductor film is removed, the film is divided into narrow card shapes, and an upper electrode is formed so as to cover these shapes. Finally, a portion of the upper electrode film is removed in a stripe-shape, and the film is divided.

The above process forms an integrated thin-film solar cell wherein a plurality of unit cells is connected in series. In order to remove a stripe-shaped part of the film once formed, a groove machining tool and a peeling tool are used. The groove machining tool and the peeling tool are disposed on a machining mechanism table via a holder. After two grooves are formed by the groove machining tool, the peeling tool peels off the thin-film between the two grooves.

### SUMMARY

As described in Japanese Unexamined Patent Application Publication No. 2002-33498, a groove is formed by the groove machining tool or the peeling tool. When peeling the thin film, it is necessary to set the mounting angle of the tool in accordance with the direction of formation of the groove. When the tool is not set at a predetermined angle with regard to the direction of formation of the groove, the desired groove width will not be obtainable, or the tip end of the tool will make only partial contact. For this reason, film peeling sometimes occurs.

In order to prevent defects as described above that arise from irregularities in the mounting angle of the tool, tool mounting angle adjustments need to be made at times such as when changing the tool. Specifically, the tool and the holder are attached to a different device used to adjust the tool angle, and tool mounting angle adjustments are made while verifying the tool with a microscope. Such adjustments are extremely troublesome and require long periods of time to complete.

An object of the present invention is to enable accurate angle adjustments through simple operations when mounting the groove machining tool into the holder.

The groove machining tool for use with a thin-film solar cell according to a first aspect is a tool retained in a holder and caused to move together with the holder in one direction over a thin film of an integrated thin-film solar cell to form a groove extending in the one direction on the thin film, the groove machining tool for use with a thin-film solar cell comprising: a tool body retained in the holder; and a blade tip part formed on a tip end part of the tool body and provided with a blade for machining the groove, the blade being disposed at a tip end of the blade tip part; wherein an angle regulation unit is disposed on the tool body so that the blade tip part is fixed in a predetermined orientation with regard to the direction of formation of the groove when being retained by the holder.

In this arrangement, the tool body is fixed in a predetermined orientation by the angle regulation unit when the tool body is being retained in the holder. For this reason, the tool can be simply mounted into the holder in the same orientation consistently without using a microscope device. Because a groove can be machined with a consistent tool orientation, the machining quality of the groove formed thereby can be stabilized.

The groove machining tool for use with a thin-film solar cell according to a second aspect is the tool of the second aspect wherein the blade tip part extends having the same width over a predetermined length along the direction of formation of the groove on the thin film; and the angle regulation unit causes the direction of extension of the blade tip part to be as aligned with the direction of formation of the groove when the tool body is retained by the holder.

In this arrangement, the blade tip part extends with the same width along the direction of formation of the groove. For this reason, machining can be continued even if the blade tip is worn down. In a tool having such a configuration, it is necessary to make the direction of extension of the blade tip part the same as the direction of formation of the groove. In this arrangement, with the tool body retained by the holder, the angle regulation unit makes the direction of extension of the blade tip part the same as the direction of formation of the groove.

The groove machining tool for use with a thin-film solar cell according to a third aspect is the tool of the second aspect wherein the blade tip part extends over the entire width of the tool body.

In this case, the strength of the blade tip part can be maintained at a high level. Also, even if the wear on the blade tip due to friction continues, the service life of the tool during which machining is possible can be extended.

The groove machining tool for use with a thin-film solar cell according to a fourth aspect is the tool according to the first aspect wherein the angle regulation unit is structured by making at least one portion of the tool body into a rectangular shape. In this case, at least one part of the tool body is rectangular. Therefore, if the rectangular part is inserted into the holder-side rectangular groove, the tool body angle can be regulated with a simple configuration.

The groove machining tool for use with a thin-film solar cell according to a fifth aspect is the tool of the fourth aspect wherein the entirety of the tool body is rectangularly shaped and has one portion functioning as the angle regulation unit.

In this case, the tool body itself is rectangular. Therefore, the angle regulation unit can be configured without special machining.

The mounting angle regulation structure of a groove machining tool for use with a thin-film solar cell according to a sixth aspect is a structure whereby a machining tool for forming a groove extending in one direction over a thin film of an integrated thin-film solar cell is attached to a holder at a predetermined mounting angle, the mounting angle regulation structure of a groove machining tool for use with a thin-film solar cell comprising a tool-side angle regulation unit formed in the groove machining tool, and a holder-side angle regulation unit formed in the holder. The holder-side angle regulation unit regulates the mounting angle of the groove machining tool with regard to the holder to a predetermined angle. The groove machining tool includes a tool body retained in the holder, and a blade tip part. The blade tip part is formed on a tip end part of the tool body and is provided with a blade tip for machining the groove, the blade tip being disposed at a tip end of the blade tip part. An angle regulation unit is disposed on the tool body so that the blade tip part is fixed in a predetermined orientation with regard to the direction of formation of the groove when being retained by the holder.

In this arrangement, the blade tip part of the groove machining tool is fixed in a predetermined orientation with regard to the direction of formation of the groove by the tool-side angle regulation unit and the holder-side angle regulation unit when the groove machining tool is being retained by the holder. For this reason, the groove machining tool can always be mounted to the holder in the same orientation through simple mounting operations, as previously stated. The machining quality of the groove formed thereby can also be stabilized.

The mounting angle regulation structure of a groove machining tool for use with a thin-film solar cell according to a seventh aspect is the structure of the sixth aspect wherein the blade tip part extends having the same width over a predetermined length along the direction of formation of the groove; and the tool-side angle regulation unit aligns the direction of extension of the blade tip part with the direction of formation of the groove when the tool body is retained by the holder.

The mounting angle regulation structure of a groove machining tool for use with a thin-film solar cell according to an eighth aspect is the structure according to the sixth aspect wherein the tool-side angle regulation unit is configured such that at least part or all of the tool body is formed in a rectangular shape; and the holder-side angle regulation unit is a rectangularly shaped groove into which the rectangularly shaped tool-side angle regulation unit fits.

In this arrangement, the groove machining tool can always be fixed to the holder in the same orientation through a simple configuration.

The mounting angle regulation structure of a groove machining tool for use with a thin-film solar cell according to a ninth aspect is the structure of the sixth aspect wherein the tool-body-side angle regulation unit is formed on an end part of the tool body and is a groove formed so as to be parallel with the direction of formation of the groove; and the holder-side angle regulation unit is a pin joined with the groove formed the an end part of the tool body.

In this arrangement, the pin disposed in the holder is joined with the groove formed in the end part of the tool body. The joint between the groove and the pin causes the groove machining tool to always be fixed to the holder in the same orientation.

The mounting angle regulation structure of a groove machining tool for use with a thin-film solar cell according to a tenth aspect is the structure of the sixth aspect wherein the tool-body-side angle regulation unit is formed on an end part of the tool body and is a tilted surface tilted with regard to the axis of the tool body; and the holder-side angle regulation unit includes a regulation surface abutting with the tilted surface.

In this arrangement, the abutment between the tilted surface formed on the end of the tool body and the regulation surface formed on the holder causes the groove machining tool to consistently be fixed to the holder in the same orientation. The tilted surface of the tool body abuts with the holder-side regulation face. Therefore, upward movement of the groove machining tool can be regulated.

The mounting angle regulation structure of a groove machining tool for use with a thin-film solar cell according to an eleventh aspect is structure of the sixth aspect wherein the tool body is formed into a cross-sectional circular shape; the tool-side angle regulation unit includes a flat surface formed on one portion of the tool body; the holder includes a hole into which the tool body is inserted; and the holder-side angle regulation unit includes a screw hole orthogonal to the hole in the holder and a screw member screwed into the screw hole, the tip end thereof abutting with the flat surface of the tool-side angle regulation unit.

The present invention, described above, can perform accurate angle adjustments with simple operations, and attach a groove machining tool to a holder.

### BRIEF DESCRIPTION OF THE DRAWINGS

FIG. 1 is an exterior perspective view of a scribe device wherein one embodiment of the present invention is used;

FIG. 2 is a front view of a holder assembly according to the first embodiment;

FIG. 3 is a side view of the holder assembly;

FIG. 4 is an exterior perspective view of a groove machining tool of a first embodiment;

FIG. 5 is a side view of a holder assembly according to a second embodiment;

FIG. 6 is an exterior perspective view of a groove machining tool of a second embodiment;

FIG. 7 is a partial view of an angle regulation structure of a third embodiment;

FIG. 8 is a side view of a portion of an angle regulation structure of a fourth embodiment;

FIG. 9 is an exterior perspective view of a portion of a groove machining tool according to a fourth embodiment;

FIG. 10 is a front view of a holder assembly of a fifth embodiment; and

FIG. 11 is a partial view along arrow Z in FIG. 10.

### DESCRIPTION OF THE PREFERRED EMBODIMENTS

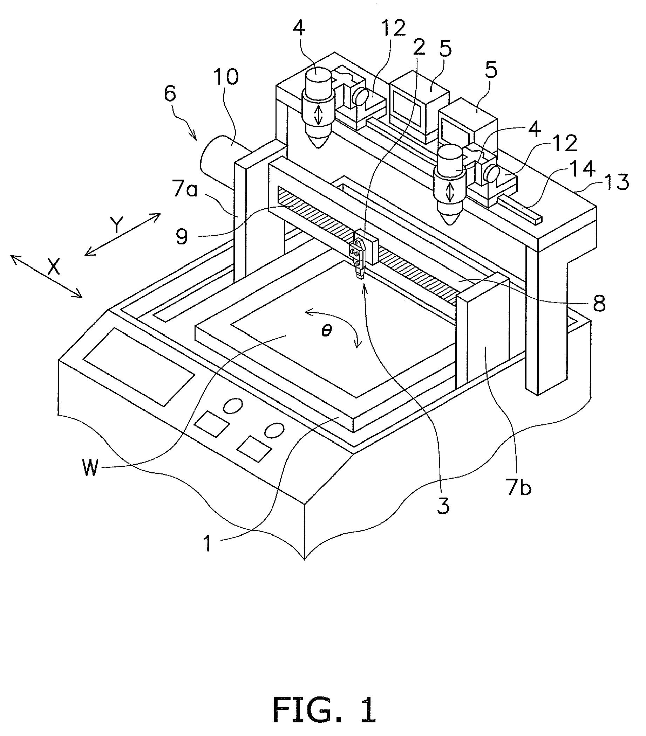

FIG. 1 illustrates an exterior perspective view of the outside of an integrated thin-film solar cell scribe device wherein a first embodiment of the present invention is used.

### First Embodiment

### General Configuration of the Scribe Device

This device includes a table 1, onto which a solar cell substrate W is placed; a scribe head 2; a holder assembly 3 installed onto the scribe head 2; two cameras 4; and two monitors 5.

The table 1 can move in the horizontal plane, in a Y direction in FIG. 1. Also, the table 1 is freely rotatable to any angle within the horizontal plane.

The scribe head 2 can move in an X direction and in the Y direction on top of the table 1 via a movement support mechanism 6. As illustrated in FIG. 1, the X direction is orthogonal to the Y direction in the horizontal plane. The movement support mechanism 6 includes one pair of support pillars 7a and 7b, a guide bar 8 crossing between the pair of support pillars 7a and 7b, and a motor 10 that moves a guide 9 formed on the guide bar 8. The scribe head 2 can move in the X direction along the guide 9, as previously stated. An air cylinder (not shown) is disposed on the scribe head 2 and the air cylinder allows the holder assembly 3 to move up and down along a linear guide.

The two cameras 4 are each fixed on pedestals 12, respectively. The pedestals 12 can move along a guide 14 that extends in the X direction and are disposed on a support stand 13. The two cameras 4 can move vertically up or down, and an image captured by each camera 4 is displayed on the corresponding monitor 5. Here, alignment marks to identify the position are disposed on a face of the solar cell substrate W. By capturing images of these alignment marks with the two cameras 4, the position of the alignment marks can be identified. Then, directional inaccuracies in the solar cell substrate W placed on the table 1 can be detected based on the identified position of the alignment marks.

### Holder Assembly

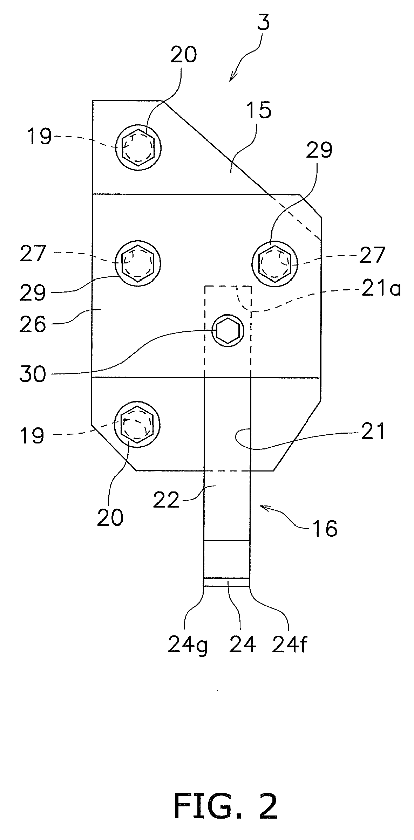

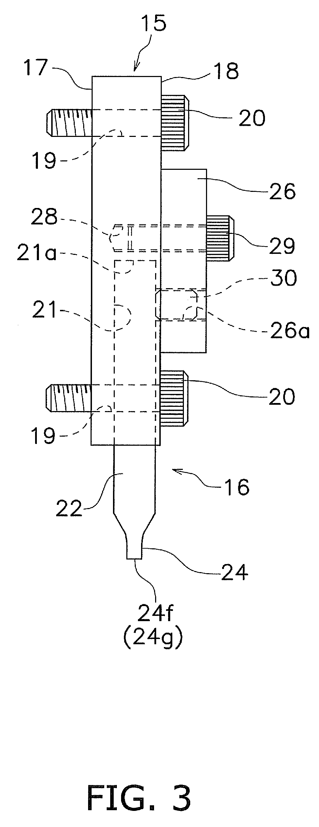

The holder assembly 3 is fixed to one face of the scribe head 2. The holder assembly 3 can move in the X and Y directions together with the scribe head 2, and can move vertically up and down with respect to the scribe head 2. The holder assembly 3 is illustrated in FIG. 2 and FIG 3. FIG. 2 is a front view of the holder assembly 3, and FIG. 3 is a side view thereof.

The holder assembly 3 includes a holder 15 fixed to the scribe head 2 and a groove machining tool 16 retained by the holder 15. An angle regulation structure is disposed on the holder 15 and on the groove machining tool 16 so that the groove machining tool 16 is mounted to the holder 15 with a predetermined mounting angle.

### Holder

The holder 15 is a plate-shaped member, and includes a first main face 17 mounted to the scribe head 2 and a second main face 18 on the opposite side. Two through holes 19 are formed vertically on the holder 15, and the holder 15 is fixed to the scribe head 2 by two bolts 20, passing completely through each through hole 19. Also, a groove 21 of predetermined length is formed on the holder 15 and runs from the bottom to the top thereof. The groove 21 is formed on the second main face 18, and is a rectangularly shaped groove having a predetermined depth. A stop face 21a is formed on the top part of groove 21. The top edge face of the groove machining tool 16 abuts the stop face 21a and thereby regulates upward movement of the groove machining tool 16.

### Groove machining tool

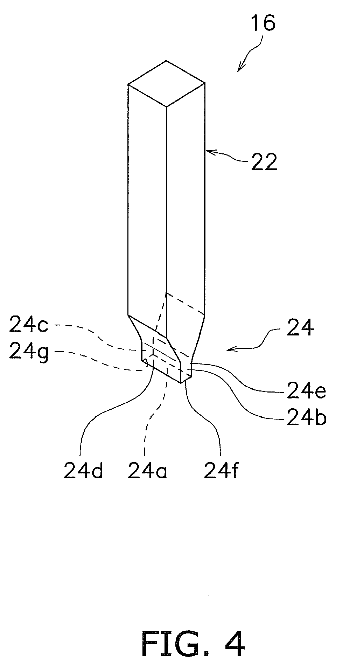

The groove machining tool 16 is inserted into the rectangular groove 21 of the holder 15, and the top edge face of the groove machining tool 16 abuts the stop face 21a of the rectangular groove 21, as previously stated. The groove machining tool 16 is formed of a hard material such as cemented carbide or sintered diamond and is constituted by a tool body 22 and a blade tip part 24. The tool body 22 is formed into a rectangular shape corresponding to the rectangular groove 21 of the holder 15. The blade tip part 24 is formed into one body with the tool body 22 at the tip end part of the tool body 22. The blade tip part 24 includes a bottom face 24a, an anterior face 24b and a posterior face 24c, and right and left faces 24d and 24e, as illustrated in FIG. 4. The bottom face 24a is formed into a rectangle. The anterior face 24b and the posterior face 24c extend upward orthogonally from the bottom face 24a, and form one flat surface with the face of the tool body 22. The right and the left faces 24d and 24e extend upward orthogonally to the bottom face 24a from the long side of the bottom face 24a and are formed so as to be parallel to each other. The tool body 22 is a tilted face tapered downward between the right and left side faces 24d and 24e.

In the groove machining tool 16 described above, angle parts 24f and 24g, which are formed from the bottom face 24a, from the anterior face 24b, and from the posterior face 24c of the blade tip part 24, each become a blade tip when the substrate is being machined. The blade tip part 24 has the same width as the blade tips 24f and 24g and is formed along a length equal to the width of the tool body 22. For this reason, even if the blade tips 24f and 24g are worn down due to friction, the width of the machined groove will not change.

The holder assembly 3 including the groove machining tool 16 is mounted to the scribe head 2 with the anterior face 24b and the posterior face 24c of the blade tip part 24 tilted with precisely a predetermined angle with regard to the solar cell substrate W; in other words, mounted so that the blade tips 24f and 24g are in contact with the substrate W.

### Angle Regulation Structure

When forming a groove on the thin film of the substrate W, the blade tips 24f and 24g of the groove machining tool 16 are placed so that the blade tips are orthogonal to the direction of extension of the groove that should be formed by the blade (the direction of formation of the groove), and the groove machining tool 16 is caused to move along the direction of formation of the groove. The blade tips 24f and 24g extend with the same width along a long direction (the direction of formation of the groove) with the same width. Therefore, even if the wearing down due to friction of the blade tip part 24 of the groove machining tool 16 progresses, continued use thereof will be possible. For that reason, the mounting angle of the groove machining tool 16 must be regulated so that the blades of the blade tips 24f and 24g are orthogonal to the direction of formation of the groove.

The angle regulation structure is disposed on the holder 15 and on the groove machining tool 16 so that the groove machining tool 16 is fixed to the holder 15 with a predetermined angle. In this embodiment, the angle of the groove machining tool 16 is set so that the blades of the blade tips 24f and 24g are orthogonal to the direction of formation of the groove.

The above angle regulation structure is configured from the rectangular groove 21 formed in the holder 15 and the tool body 22, being rectangular. In other words, the angles of the blade tips 24f and 24g of the groove machining tool 16 can be fixed with respect to the holder 15 by inserting the tool body 22, being rectangular, into the rectangular groove 21.

The angle regulation structure includes an attachment plate 26 in addition to the rectangular groove 21 and the tool body 22, being rectangular. Two through holes 27 are formed being aligned horizontally on the attachment plate 26. The attachment plate 26 is attached to the second main face of the holder 15 by two bolts 29 that are screwed into the corresponding screw holes 28 of the holder 15 and that pass through each of the through holes 27. In this way, the attachment plate 26 covers approximately the upper one third of the groove machining tool that was inserted into the rectangular groove 21 of the holder 15.

A screw hole 26a is formed that passes through the attachment plate. The screw hole 26a is disposed in a position that enables it to touch the groove machining tool 16 when the attachment plate 26 is fixed to the holder 15. The tip end of a screw member 30 presses the groove machining tool 16 against the bottom face of the rectangular groove 21 because the screw member 30 is screwed into the screw hole 26a. The groove machining tool 16 is thereby prevented from falling from the rectangular groove 21.

### Operation

As previously stated, the groove machining tool 16 is set into the scribe head 2 so that the long direction of the bottom face 24a follows the direction of formation of the groove (the direction of motion of the tool) and so that the blade tips 24f and 24g are orthogonal to the direction of formation of the groove. The groove machining tool 16 is set into the scribe head 2 in a state wherein the anterior face 24b and the posterior face 24c of the blade tip part 24 are tilted precisely at a predetermined angle with respect to the solar cell substrate W.

In a state such as the one above, the holder assembly is caused to descend every time the table 1 is caused to move at a predetermined pitch, and the blade tips 24f and 24g of the groove machining tool 16 are pressed against the surface of the solar cell substrate W. A groove is formed along the X direction on the surface of the solar cell substrate W by causing the holder assembly 3 to move in the X direction.

### Characteristics

In this embodiment, the tool body 22, being rectangular, is inserted into the rectangular groove 21 of the holder 15 and the mounting angle of the groove machining tool 16 is regulated. For this reason, the groove machining tool 16 can consistently be mounted to the holder 15 in the same orientation with an extremely easy configuration and by a simple mounting operation. Therefore, the machining quality of the groove formed by such a groove machining tool 16 is stabilized.

The blade tip part 24 of the groove machining tool 16 extends continually along the entire length of the tool body at the same width and in the direction of formation of the groove. For this reason, even if the blade tip is worn down due to friction, machining can be continued and the service life of the tool can be extended.

### Second Embodiment

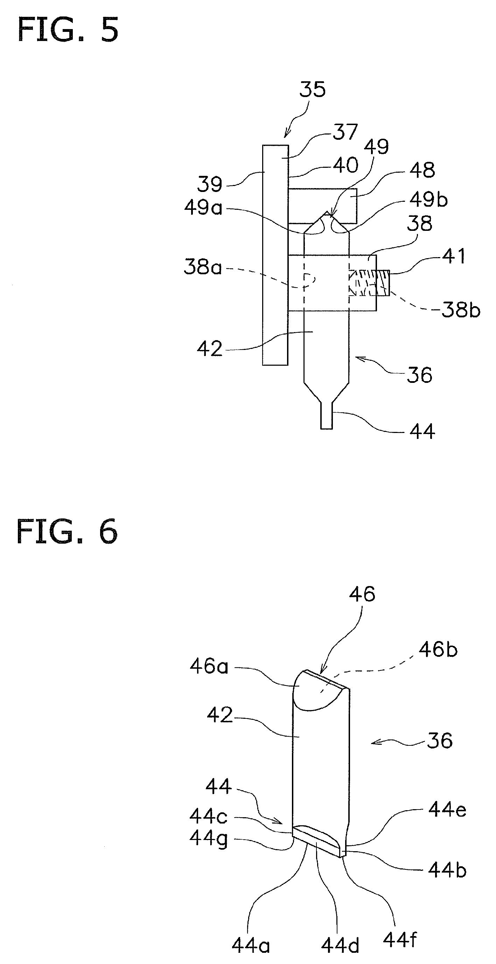

FIG. 5 and FIG. 6 illustrate a second embodiment of the holder and the groove machining tool. The configuration of the second embodiment is the same as the configuration of the first embodiment except for a holder 35 and a groove machining tool 36. Holder

The holder 35 includes a baseplate 37 and a support block 38. The baseplate 37 includes a first main face 39 that is mounted into the scribe head 2 and a second main face 40 on the opposite side. As previously stated, a plurality of through holes (not shown) is formed on the baseplate 37 of the holder 35. The holder 35 is fixed to the scribe head 2 by bolts that pass through the through holes.

The support block 38 is fixed to the second main face 40 of the baseplate 37. The method of fixation of the support block 38 to the baseplate 37 is not limited, and can be by a bolt, a weld, inclusion into a single body, or by other methods. A circular through hole 38a passing vertically is formed on the support block 38. The groove machining tool 36 is inserted into the through hole 38a and retained thereby. The structure used to fix the groove machining tool 36 that is inserted into the through hole 38a of the support block 38 is the same as that in the first embodiment. In other words, the groove machining tool 36 is retained by the support block 38 by the screw hole 38b formed passing through from the outside face to the through hole 38a on the support block 38 and a screw member 41 that abuts the outside face of the groove machining tool 36 and is screwed into the screw hole 38b.

### Groove Machining Tool

The groove machining tool 36 is an object formed by machining a circular bar. The groove machining tool 36 is formed from cemented carbide, diamond, or another hard material, and is composed of a tool body 42 and a blade tip part 44. The tool body 42 is a cross-sectional circular form corresponding to the circular form of the through hole 38a. The blade tip part 44 is formed into a single body with the tool body 42 at the tip end part of the tool body 42. The blade tip part 44 is of completely the same composition as that of the first embodiment. In other words, the blade tip includes a bottom face 44a; an anterior face 44b; a posterior face 44c; and right and left faces 44d and 44e, respectively, as illustrated in FIG. 6. The angle parts 44f and 44g formed from the bottom face 44a and the anterior and posterior faces 44b and 44c of the blade tip part 44 become blade tips when machining a substrate, the same as in the first embodiment.

### Angle Regulation Structure

In the second embodiment, the angle regulation structure is composed of a tool-side angle regulation unit and a holder-side regulation unit.

The tool-body-side angle regulation unit is composed of tilted surfaces 46a and 46b of the protuberance part 46, formed on the upper end of the tool body 42. To be more specific, the upper end of the tool body 42 is formed into a triangular shape as viewed from the side. In other words, the upper end of the tool body 42 is tapered upward, becoming thinner at the upper end of the body, as viewed from the side. The upper end of the tool body 42 has a first tilted surface 46a on the baseplate 37 side, and on the opposite side has a tilted surface 46b. Therefore, the first and second tilted surfaces 46a and 46b, respectively, formed by the protuberance part 46 extend along the direction of formation of the groove. The direction of formation of the groove is the direction of extension of the blade tip part 44.

The holder-side angle regulation unit is a positioning block 48 disposed on the second main face 40 of the baseplate 37, which forms the holder 35. A cross-sectional inverted V shaped groove 49 is formed on the positioning block 48. The groove 49 extends along the direction of formation of the groove. The first tilted surface 46a and the second tilted surface 46b of the protuberance part 46 of the groove machining tool 36 each abuts a wall surface (regulation surface) 49a and 49b on both sides of the groove, respectively.

In this way, the mounting angle of the groove machining tool 36 with respect to the holder 35 is regulated by the tilted surfaces 46a and 46b disposed on the groove machining tool 36 and the regulation surfaces 49a and 49b of the groove 49 of the positioning block 48 that is disposed on the holder 35. The positioning block 48 regulates the upward motion of the groove machining tool 36.

Even according to such an embodiment, the groove machining tool 36 can consistently be mounted to the holder 35 in the same orientation using a simple mounting operation. The machining quality of the groove formed by the groove machining tool 36 is stabilized. Also, as previously stated, the tool service life of the groove machining tool 36 can be extended.

### Third Embodiment

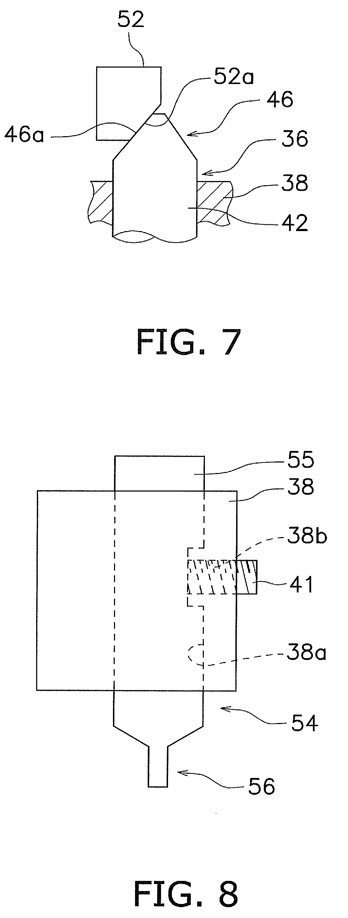

FIG. 7 illustrates a third embodiment. In the third embodiment, only the holder-side angle regulation unit is different from the second embodiment. The other configurations are the same as the second embodiment.

As illustrated in FIG. 7, a positioning block 52 from which the holder-side angle regulation unit is constructed includes only one tilted surface 52a. The tilted surface 52a extends along the direction of formation of the groove, as previously stated, and has the same angle of tilt as that of the protuberance part 46 of the tool body 42, which forms the tool-side angle regulation part. Regulation of the mounting angle of the groove machining tool 36 with respect to the holder 35 and regulation of upward movement is possible by causing the first tilted surface 46a and the second tilted surface 46b of the protuberance part 46 of the groove machining tool 36 to abut with the tilted surface 52a

### Fourth Embodiment

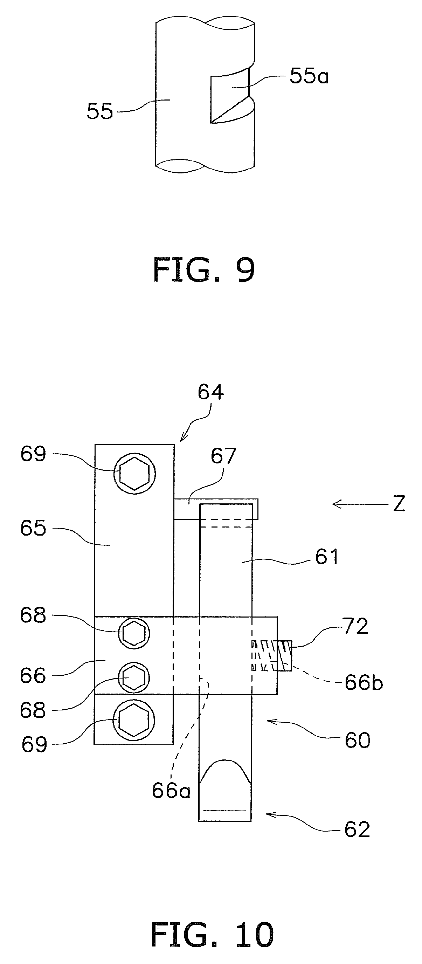

FIG. 8 and FIG. 9 illustrate a fourth embodiment. In the fourth embodiment a groove machining tool 54 is formed by machining a circular bar, and includes a tool body 55, a cross section of which is circular, and a blade tip part 56 formed at the tip end part of the tool body 55. The configuration of the blade tip part 56 is completely the same as the previously discussed embodiments. Therefore, the configuration thereof will not be discussed herein. The holder is the same as the holder 35 of the second embodiment and has a support block 38. A through hole 38a and a screw hole 38b are disposed on the support block 38. There is no positioning block in the fourth embodiment.

The tool-side angle regulation unit is composed of a flat surface part 55a formed from one part of the tool body 55. The flat surface part 55a is cut from a part of the outer circumference of the tool body 55 and formed in a direction orthogonal to the axis direction and parallel to the direction of formation of the groove (the direction of extension of the blade tip).

On the other hand, the holder-side angle regulation unit is composed of a screw hold 38b of the support block 38, from which the holder is composed; and a screw member 41. In other words, the mounting angle of the groove machining tool 54 with regard to the holder is regulated by causing the tip end of the screw member 41 which is screwed into the screw hole 38b of the support block 38 to abut with the flat surface part 55a of the tool body 55.

As described above, in the fourth embodiment the angle regulation structure is composed of the flat surface part 55a of the tool body 55 , the screw hole 38b, and the screw member 41 of the support block 38 which is screwed into the screw hole 38b. Vertical movement of the groove machining tool 54 with regard to the holder is regulated by the angle regulation structure.

### Fifth Embodiment

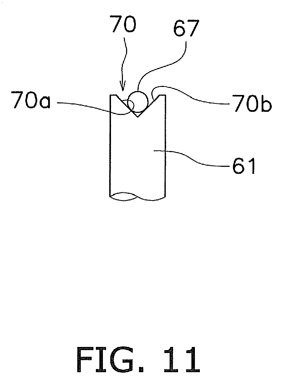

FIG. 10 and FIG. 11 illustrate a fifth embodiment. FIG. 11 is an arrow view of the Z direction of FIG. 10. In the fifth embodiment a groove machining tool 60 is formed by machining a circular bar, and includes a tool body 61, a cross section of which is circular, and a blade tip part 62 formed from the tip end part of the tool body 61. The blade tip part 62 is exactly the same as the previous embodiments. Everything other than the groove machining tool and the holder has the same configuration as the previous embodiments.

A holder 64 includes a base member 65 made up of a block member in a rectangular shape, a support block 66, and an angle regulating pin 67.

A through hole 66a is formed vertically on the support block 66 and a screw hole 66b is formed horizontally thereon. The screw hole 66b is the same as in the previous embodiments and is formed so that it passes from the outer circumferential face of the support block 66 to the through hole 66a. The base member 65 is fixed to the scribe head 2 by two bolts 69. The support block 66 is fixed to the base member 65 by two bolts 68.

The tool-side angle regulation unit is a V shaped groove 70 formed on the upper end of the tool body 61. The V groove 70 is formed being parallel with the direction of the groove (the direction of extension of the blade tip) and is formed on the surface of the substrate.

On the other hand, the holder-side angle regulation unit is composed of the pin 67, previously described. The groove machining tool 60 is attached to the support block 66 so that both of the wall faces 70a and 70b of the V groove of the tool body 61 respectively abut with the outer circumferential face of the pin 67.

As described above, in the fifth embodiment the angle regulation structure is comprised of the V groove 70 of the tool body 61 and a pin 67 disposed on the holder 64. Vertical motion of the groove machining tool 60 with respect to the holder is regulated by the angle regulation structure.

The configuration allowing the groove machining tool 60, inserted into the through hole 66a of the support block 66, to be fixed in order to not descend is the same as that in the first embodiment. In other words, the groove machining tool 60 is retained by the screw member 72 that abuts the outer circumferential face of the groove machining tool 60 and is screwed into the screw hole 66b of the support block 66.

### Other Embodiments

The present invention is not limited by the above embodiments. Various modifications and variations are possible without exceeding the scope of the present invention.

In each of the previously described embodiments, the direction of extension of the tilted surface, the direction of the pin, the direction of the groove, etc. are not limited to the directions illustrated in the drawings. As long as the aforementioned parts regulate the mounting angle of the groove machining tool by means of abutment, they may be formed in any direction.

### GENERAL INTERPRETATION OF TERMS

In understanding the scope of the present invention, the term "comprising" and its derivatives, as used herein, are intended to be open ended terms that specify the presence of the stated features, elements, components, groups, integers, and/or steps, but do not exclude the presence of other unstated features, elements, components, groups, integers and/or steps. The foregoing also applies to words having similar meanings such as the terms, "including", "having" and their derivatives. Also, the terms "part," "section," "portion," "member" or "element" when used in the singular can have the dual meaning of a single part or a plurality of parts. Finally, terms of degree such as "substantially", "about" and "approximately" as used herein mean a reasonable amount of deviation of the modified term such that the end result is not significantly changed. For example, these terms can be construed as including a deviation of at least ± 5% of the modified term if this deviation would not negate the meaning of the word it modifies.

While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims and their equivalents.
To be able to accurately adjust an angle using a simple operation when mounting a groove machining tool into a holder, there is provided a groove machining tool for use with a thin-film solar cell. The groove machining tool is retained by a holder, is caused to move together with the holder over a thin film of an integrated thin-film solar cell in one direction, and forms a groove on the thin film extending in one direction and has a tool body. The blade tip part is formed on a tip end of the tool body and has blade tips for machining grooves disposed at a tip end. An angle regulation unit is disposed on the tool body so that the blade tip part is fixed in a predetermined orientation with regard to the direction of formation of the groove when being retained by the holder.

## Claims

1. A machining tool retained in a holder and caused to move together with the holder in one direction over a thin film of an integrated thin-film solar cell to form a groove extending in the one direction on the thin film, the groove machining tool comprising:
a tool body retained in the holder;
a blade tip part formed on a tip end part of the tool body and provided with a blade for machining the groove, the blade being disposed at a tip end of the blade tip part; and
an angle regulation unit being disposed on the tool body so that the blade tip part is fixed in a predetermined orientation with regard to the direction of formation of the groove when being retained by the holder.

2. The groove machining tool for use with a thin-film solar cell according to claim 1, wherein
the blade tip part extends with the same width over a predetermined length along the direction of formation of the groove on the thin film, and
the angle regulation unit aligns in the direction of extension of the blade tip part with the direction of formation of the groove when the tool body is retained by the holder.

3. The groove machining tool for use with a thin-film solar cell according to claim 2, wherein
the blade tip part extends over the entire width of the tool body.

4. The groove machining tool for use with a thin-film solar cell according to claim 1, wherein
the angle regulation unit is structured by making at least one portion of the tool body into a rectangular shape.

5. The groove machining tool for use with a thin-film solar cell according to claim 4, wherein
the entirety of the tool body is rectangularly shaped and has one portion functioning as the angle regulation unit.

6. A mounting angel regulation structure for which a machining tool for forming a groove extending in one direction over a thin film of an integrated thin-film solar cell is attached to a holder at a predetermined mounting angle, the mounting angle regulation structure comprising:
a tool-side angle regulation unit formed in the groove machining tool;
a holder-side angle regulation unit formed in the holder and used to regulate the mounting angle of the groove machining tool with regard to the holder to a predetermined angle,
the groove machining tool including
a tool body retained in the holder, and
a blade tip part formed on a tip end part of the tool body and provided with
a blade tip for machining the groove, the blade tip being disposed at a tip end of the blade tip part; and
an angle regulation unit disposed on the tool body so that the blade tip part is fixed in a predetermined orientation with regard to the direction of formation of the groove when being retained by the holder.

7. The mounting angle regulation structure of a groove machining tool for use with a thin-film solar cell according to claim 6, wherein
the blade tip part extends with the same width over a predetermined length along the direction of formation of the groove, and
the tool-side angle regulation unit aligns the direction of extension of the blade tip part with the direction of formation of the groove when the tool body is retained by the holder.

8. The mounting angle regulation structure of a groove machining tool for use with a thin-film solar cell according to claim 6, wherein
the tool-side angle regulation unit is configured such that at least part or all of the tool body is formed in a rectangular shape, and
the holder-side angle regulation unit is a rectangularly shaped groove into which the rectangularly shaped tool-side angle regulation unit fits.

9. The mounting angle regulation structure of a groove machining tool for use with a thin-film solar cell according to claim 6, wherein
the tool-side angle regulation unit is formed on an end part of the tool body and is a groove formed so as to be parallel with the direction of formation of the groove, and
the holder-side angle regulation unit is a pin joined with the groove formed the an end part of the tool body.

10. The mounting angle regulation structure of a groove machining tool for use with a thin-film solar cell according to claim 6, wherein
the tool-side angle regulation unit is formed on an end part of the tool body and is a tilted surface tilted with regard to the axis of the tool body;, and
the holder-side angle regulation unit includes a regulation surface abutting with the tilted surface.

11. The mounting angle regulation structure of a groove machining tool for use with a thin-film solar cell according to claim 6, wherein
the tool body is formed into a circular bar shape,
the tool-side angle regulation unit includes a flat surface formed on one portion of the tool body,
the holder includes a hole into which the tool body is inserted, and
the holder-side angle regulation unit includes a screw hole orthogonal to the hole in the holder and a screw member screwed into the screw hole, the tip end thereof abutting with the flat surface of the tool-side angle regulation unit.
